# EUROPEAN PATENT APPLICATION

(11) **EP 1 939 837 A2**
(43) Date of publication of application: **02.07.2008**
(21) Application number: 07122896.9
(22) Date of filing: 11.12.2007
(51) Int. Cl.: G09B 29/00, G01C 21/32

(54) **Lossless real-time compression of geographic data**

(30) Priority: 20.12.2006 US 613630
(71) Applicant: AT&T Corp., New York, NY 10013-2412 (US)
(72) Inventor: Asher, Michael, Green Cove Springs, FL 32043 (US)
(74) Representative: Harding, Richard Patrick

(57) **Abstract**

A method and apparatus for compressing geographic information services (GIS) data is provided. GIS data comprising a first set of data points representing a latitude and longitude is transformed into a compressed second set of data points by using one data point as a reference point and defining all data points with respect to the reference point using a scaling factor, with the second set of data points requiring fewer bytes of data than the first set. The compressed data, reference point, and scaling factor can be transmitted in response to a query for GIS data, and the original data can be recovered by performing the transformation in reverse with no loss of data.

## Description

### FIELD OF ART

Aspects described herein relate to a method for efficient compression of geographic coordinate data that permits lossless decompression and recovery of the data with little or no computational overhead.

### BACKGROUND

The manipulation of geographic data by computer systems is becoming increasingly prevalent. Detailed databases containing geographic data (commonly known as geographic information services (GIS) data) enable users to enter an address and retrieve a map showing the requested address and surrounding area. In a typical system, the geographic data in the database consists of latitude/longitude pairs or, in a three-dimensional system, tuples comprising latitude, longitude, and elevation coordinates. This coordinate data can be used to form a point representing a specific location; a line representing, for example, a street or a range of specific locations; or a polygon representing a larger area. This data is often transmitted over a client-server or a multi-tiered architecture and, for detailed views, can consume enormous bandwidth. For example, it is not uncommon for several megabytes of data or more to be required just to render a single map image of an area. As a consequence, multiuser GIS data servers can be required to process and return map data at a rate of 1GB/second or even higher.

Increasingly, such databases are accessed and GIS data are retrieved by use of mobile devices such as web-enabled cell phones or portable computers. In addition, computer-based navigation systems such as those based on Global Positioning System (GPS) software have rapidly proliferated, and are now commonplace components in automobiles or in stand-alone portable devices. Such computer systems may have relatively limited computer resources such as limited memory and relatively slow input/output. Thus, the bandwidth limitations of devices used to request and receive GIS data, combined with the bandwidth requirements involved in generating and returning the requested GIS data to the requestor, make compression of the data stream flowing from the GIS data server to the user highly desirable. For example, data compression can reduce the memory required to receive and process GIS data, and thus significantly can improve performance. In addition, in cases where bandwidth is purchased, data compression can reduce the bandwidth needed and thus result in cost savings.

Numerous data compression techniques exist in the art. For example, one method of compressing data from a geographic database, described in U.S. Patent 6,393,149 to Friederich et al., involves searching a data stream for a plurality of data characters that matches a plurality of data characters at a first position in the string and then replacing those matching characters with a substitution code, i.e., a reference to the characters at the first position. The data are decompressed by reversing the process, i.e., by searching through the compressed data stream and replacing the substitution codes with sub-strings of the appropriate data. This method, however, as well as other data compression techniques known in the art, require significant computational time, and thus are unsuitable for real-time demand-based applications.

### SUMMARY

This summary is intended to introduce, in simplified form, a selection of concepts that are further described in the Detailed Description. This summary is not intended to identify key or essential features of the claimed subject matter, nor is it intended to be used as an aid in determining the scope of the claimed subject matter.

Aspects described herein relate to the need for a method of encoding GIS data to obtain a large compression ratio with little or no computational overhead and without loss of positional accuracy or functionality. A method for encoding GIS data is provided which uses the latitude/longitude coordinates of one point as a reference point and transforms the coordinates of the other points of interest into relative values based on the reference point and a scaling factor. The substitution of relative values for absolute values results in the use of significantly fewer bytes of data to render the information. The original data points can be retrieved by a simple reverse transformation, requiring only a trivial amount of computational overhead. In some cases, no reverse transformation may be needed, as the compressed data can be directly utilized by the client application.

### BRIEF DESCRIPTION OF THE DRAWINGS

FIG. 1 depicts a display of a query page for a GIS database as known in the art.

FIG. 2 depicts a display of the results of a query from a GIS database as is known in the art.

FIG. 3 depicts a display of the results of a query from a GIS database showing latitude/longitude coordinates as is known in the art.

FIG. 4 depicts a result from a coordinate transformation according to one or more aspects described herein.

FIG. 5 depicts elements of a system that can be used to generate and output a display of results from a coordinate transformation according to one or more aspects described herein.

FIG. 6 depicts a logic flow that can be used by a processor to generate and output compressed GIS data according to one or more aspects described herein.

### DETAILED DESCRIPTION

The various aspects summarized previously can be embodied in various forms. The following description shows, by way of illustration, various combinations and configurations in which the aspects can be practiced. It is understood that the described aspects and/or embodiments are merely examples, and that other aspects and/or embodiments can be utilized, and structural and functional modifications can be made, without departing from the scope of the present disclosure. For example, aspects are described herein in the context of a GIS database that is accessed by means of a query from a user and which returns information in response to that query. It should be noted, however, that a specific query by a user is not needed and that one or more described aspects can be used in any context where GIS data is provided, such as in the context of a client application automatically requesting GIS data without user input or in the context of providing geographic information to locate objects based on GPS signals.

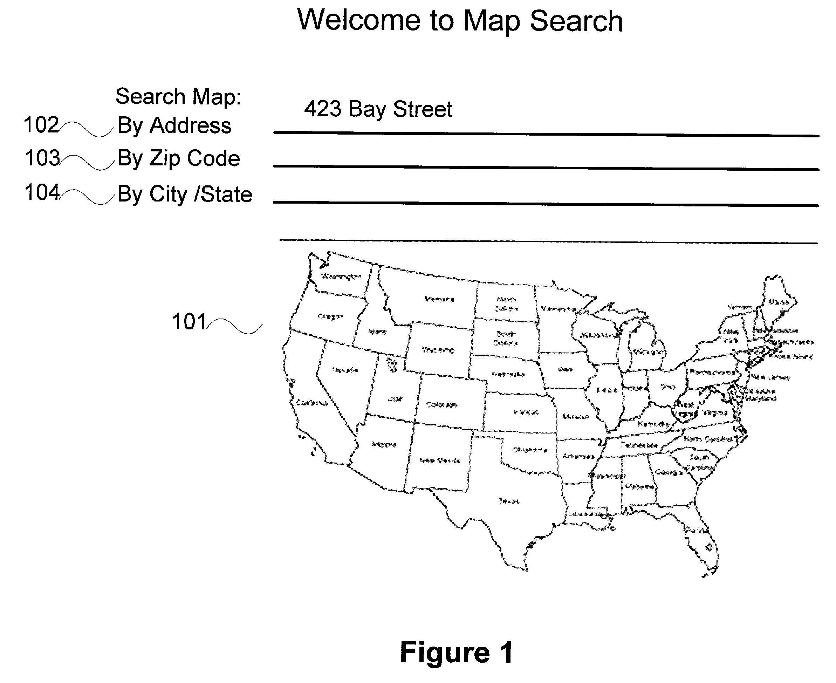

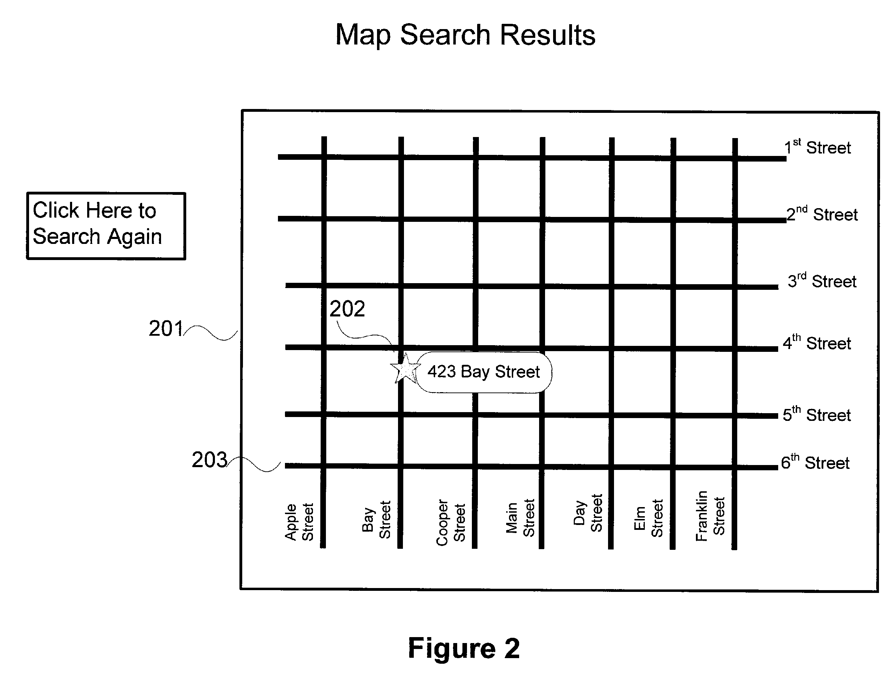

FIG. 1 shows a typical query page for a GIS database as known in the art. Such a query page can permit a user to enter information regarding a desired location on a map (101), such as an address (102), ZIP code (103), or city and state (104) and obtain a map showing the requested location. The map that is returned may vary depending on the nature of the search and the parameters of the navigation database software used. For example, if a user enters a street address, the database may return a map such as is shown in FIG. 2, which displays a rectangular area (201), the requested address (202), and an area (203) surrounding the requested address.

Construction of such a map by the software can often require several megabytes of data or more. Since GIS data for geographic features is stored in terms of latitude/longitude value pairs, map generation software known in the art will draw the map based on the latitude and longitude values of the geographic features therein, and will transmit those values to define the map generated in response to a user's query. Typically, this raw coordinate data is encoded as a binary floating-point or fixed-point value. Depending on the accuracy needed for a given map, this requires 4, 8, or even 12 bytes of data per value. A latitude/longitude point requires two such values, one for each of the latitude value and the longitude value, and thus requires 8 to 12 bytes of data. Some implementations are even more inefficient, transmitting the data as a text representation requiring up to 30 bytes per point. Since a map may contain several hundred data points, rendering even a simple map may require many megabits of data.

Thus, it can be seen that rendering even a small map containing only a few geographic features can require large amounts of data to be passed from the GIS data server to the user's device. Such large amounts of data require significant computer overhead, either in terms of the memory required to receive and store this information or the bandwidth needed to transmit and receive it. Aspects of a system and method for data compression as described herein can reduce the computer overhead needed to render such maps.

The data savings are the consequence of the domain dependency of a typical GIS view. A latitude/longitude pair represents an absolute point anywhere on the earth's surface. For example, the latitude/longitude pair [38.889 N, -077.036 W] gives the location of the Washington Monument in Washington, D.C. However, any map depicting the Washington Monument or even a larger surrounding area of Washington, D.C. is typically a very small fraction of the earth's surface, often a few square kilometers or less. If the coordinates of objects within that map were given relative to the view shown in the map rather than in absolute terms, the domain of the data needed can drop, often by as much as several orders of magnitude.

For example, a map of a specified location and the surrounding area can be defined by the latitude/longitude points for points on the perimeter such as the four corners of a square. According to one or more aspects described herein, these four corners can be described not by their absolute latitude and longitude values but instead by relative values based on their distance from some fixed point. The relative values can require significantly fewer bytes of data per point and thus need significantly less memory to store and less bandwidth to transmit. The dataset of relative values can be transmitted to the client application together with an initial absolute reference point and a scaling factor used to transform the absolute values to relative ones. The client application can then reconstruct the original dataset from the reference point, relative values and scaling factor, using a simple arithmetic transformation requiring only a trivial amount of computational overhead. The result is reconstruction of the original dataset at the client with a significantly reduced need for memory and bandwidth during transmission from the server. In some cases, no reverse transformation may be needed, as the compressed data can be directly utilized by the client application, such as where the scaling factor maps directly into a client viewspace.

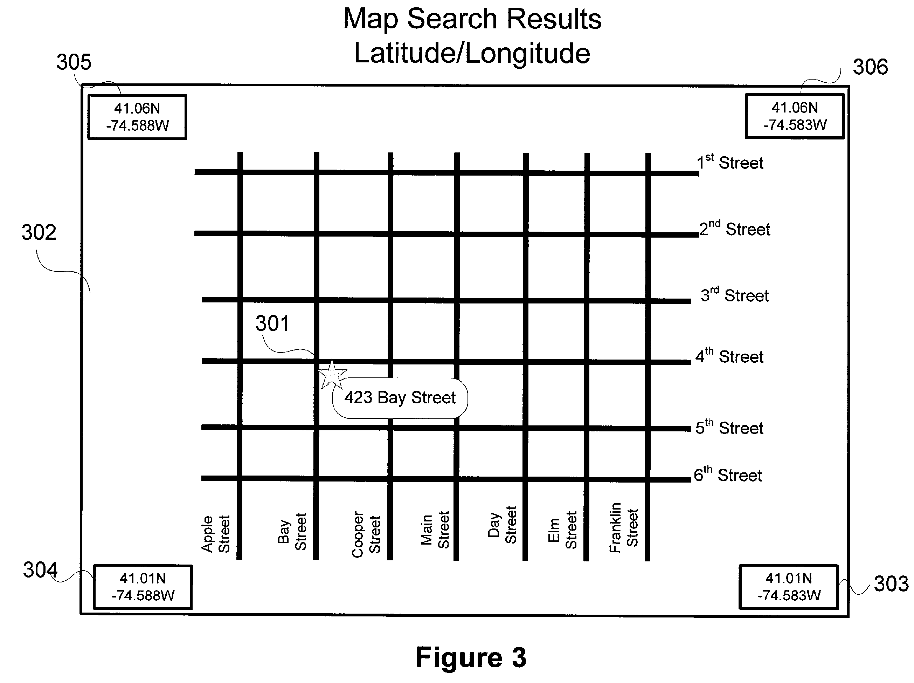

As an exemplary illustration of a coordinate transformation in accordance with one or more aspects described herein, consider geographical information such as a map as shown in FIG. 3. FIG. 3 shows a map (301) drawn in response to a query for an address (302) as shown in FIG. 1. The returned map depicts a portion of the earth comprising a square represented by the following latitude/longitude values: [41.01N, -74.583W] (303); [41.01N, -74.588W] (304); [41.06N, -74.588W] (305); and [41.06N, -74.583W] (306). Using known data transmission methods, transmitting this map would require transmission of data regarding four points, one for each corner of the square. Each point requires two values, one for each of the latitude and longitude. Thus, if each value requires 8 bytes of data, transmission of this map requires a total of 64 bytes of data.

In accordance with one or more aspects described herein, the data required to transmit such geographical information and render a map as shown in FIG. 2 can be significantly reduced by the use of relative rather than absolute values to describe one or more of the necessary data points. In accordance with one or more aspects described in more detail below, one point of a geographic area can be defined to be a base point. A scaling factor can be given to permit the translation of the absolute coordinates to relative coordinates, and in such a case, the other points can then be defined in terms of their values relative to that base point rather than in absolute values.

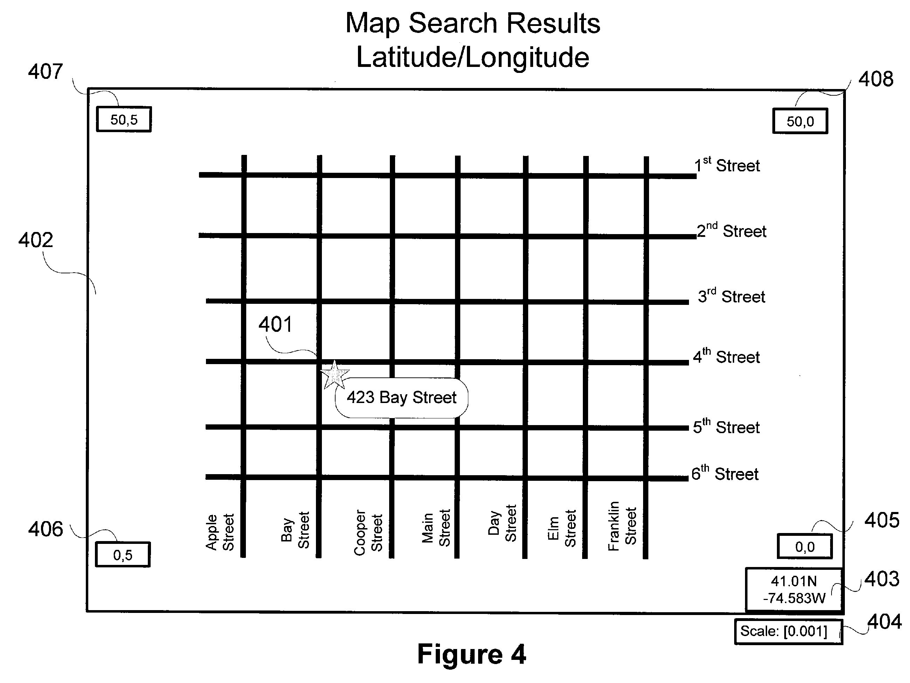

Using the exemplary geographical square defined above, relative values in accordance with aspects herein can be defined and transmitted by prefacing the data values with a tag representing a coordinates of a corner point and a relative scale factor, and using the corner point and the scale factor to define the points on the map. For example, the values described in FIG. 3 can be defined and transmitted using a reference point, scaling factor, and relative data points as follows and as shown in FIG. 4 for a map (402) showing an address (401) requested by a client application: [Comer] [41.01N, - 74.583W] (403); [Scale] [0.001] (404); [0,0] (405); [0,5] (406); [50,5] (407); [50,0] (408). Thus, a corner point is given in terms of its absolute values, for example, in the exemplary illustration above, latitude/longitude values of [41.01N, -74.583W] (403). A scaling factor is given, and in the exemplary illustration has a value of [0.001] (404). All points needed to define the area, including the corner point, can then be given in terms of their values relative to the corner point based on the scaling factor. Thus, the corner point can be represented by "[0,0]" (405) because its coordinates have no change from the reference point. The next point can be represented by "[0,5]" (406) because its coordinates, [41.01N, -74.588W] (304), can be represented in terms of their values relative to the reference point in accordance with the scaling factor. Thus, the latitude value 41.01N is given a relative value "0" because it has no change from the reference point. The longitude value -74.588W is given a relative value "5" because its value is 5 x 0.001 (i.e., 5 x the scaling factor) from the reference point. The other points can similarly be expressed in terms of their values relative to the reference point in accordance with the scaling factor.

Using a set of relative values such as those described above permits the use of low-precision 2-byte integers to describe the map rather than the 8-byte data values required by describing the map in absolute coordinates. Thus, the map described above would require eight 2-byte values for the relative points, for a total of 16 bytes, rather than 64 bytes, or only one-quarter of the original amount of data and resulting in an effective data compression ratio of 75%. The extra data overhead from transmitting the transformation tag is trivial. More significantly, only a single transformation tag consisting of a single reference point and scaling factor need be transmitted for a view consisting of hundreds or thousands of detailed objects, with the remaining objects being defined only in terms of their relative positions based on the reference point and scaling factor.

Transmitting coordinate data in using relative values in accordance with one or more aspects described herein can result in significant space savings in the amount of data required to transmit geographic coordinate information, and can thus reduce the amount of bandwidth required to transmit such information. These space savings can also allow significantly faster transmission of geographic data in a client-server or multi-tiered software architecture. This can result in increased performance and, in cases where bandwidth is purchased, can result in significant cost savings as well. Unlike systems which transform coordinates from a world space into screen space (i.e., pixels) for transmission, the use of a fixed point, scaling factor, and relative values in accordance with one or more aspects to transmit geographic data can allow the application to zoom and scale a view without distortion or inaccuracy, because the compression is fully lossless, and therefore there is no error or reduction in the data. Furthermore, most GIS systems progressively render more data as the image is zoomed in and the magnification level shrinks, and therefore, the benefits of a data compression method in accordance with one or more aspects described herein that transmits data using relative values can be especially realized where it is most needed, i.e., for high-resolution views of small areas.

An encoding algorithm in accordance with one or more aspects described herein can also be combined with other data optimization methods known in the art, such as traditional data compression, node removal/interpolation, and accuracy reduction. The data-savings effects of such a combination can be cumulative and can work well with each other.

In addition, compressed data produced in accordance with one or more aspects described herein can experience standard geometric and GIS operations directly without the data having to be decompressed. For example, in a three-tier architecture, a GIS server can send compressed data to a middle-tier business rules broker. That broker can then operate directly on the data, performing operations such as intersection or union of two or more polygons representing a geographical area, without having to decompress the data. The broker can then send the resulting data, still in compressed form, to a remote client. Thus, the data can be created, transmitted, manipulated, and retransmitted, all in compressed form without having to be decompressed at any stage.

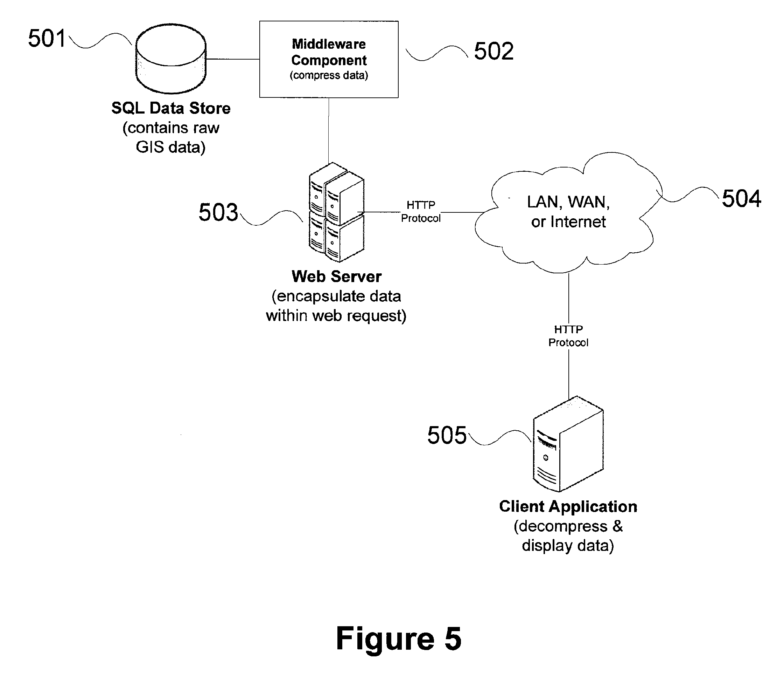

System elements that can be used in a data compression method according to one or more aspects described herein are now described with reference to elements shown in FIG. 5. As shown in FIG. 5, raw GIS data can reside in a SQL (Structured Query Language) data store (501) well known in the art. The raw GIS data can be retrieved by a middleware component (502), which can be, for example, an ORB broker, a J2EE server, or a Corba or XML-based web service, or directly by a server (503), for example, a web server. At server (503), the compressed GIS data can be encapsulated within the data to be returned in response to a query, for example, over the Internet. The query response containing the encapsulated compressed GIS data can be sent using any standard data transmission protocol, for example, a standard HTTP protocol in the case of an Internet-based application, to a LAN, a WAN, or the Internet (504), and from there sent, again using any standard data transmission protocol, to a client application (505), where the compressed GIS data can be decompressed and displayed to a user. The client application can reside on any device that can receive data, such as a PC, a laptop computer, a handheld computer, or a computer in a mobile setting, such as a GPS system residing in an automobile.

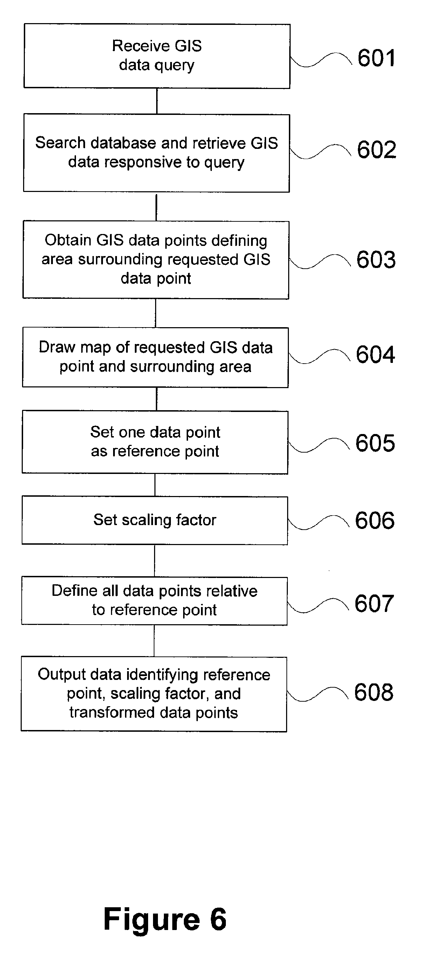

FIG. 6 depicts a logic flow that can be used by a processor to generate and store compressed data representing GIS data points in accordance with one or more aspects. At step (601), the processor receives a request for GIS data, for example, in the form of query for GIS data point representing a specific address. At step (602), the processor searches the database and retrieves GIS database responsive to the query. At step (603), the processor obtains GIS data points defining an area surrounding the requested GIS data point, and at step (604) the processor draws a map of the requested GIS data point and the surrounding area based on the retrieved data points. At step (605), the processor sets one GIS data point as a reference point to be used to generate relative data points in accordance with one or more aspects herein. At step (606), the processor sets the scaling factor to be used to generate the relative data points. At step (607), using the reference point set at step (605) and the scaling factor set at step (606), the processor transforms all data points in the map from absolute to relative values based on the reference point and scaling factor. At step (608), the processor returns an answer to the query by outputting data identifying the reference point, the scaling factor, and the transformed data points defining the requested map and the surrounding area.

Although the present invention has been described in terms of preferred and exemplary embodiments thereof, numerous other embodiments, modifications, and variations within the scope and spirit of the appended claims will occur to persons of ordinary skill in the art from a review of this disclosure.

## Claims

1. A method for providing geographic information services (GIS) data, including:
defining a geographic area based on a first plurality of GIS data points, each of the first plurality of GIS data points being defined by at least two data values representing at least a latitude and a longitude for the GIS data point;
setting one of the first plurality of GIS data points as a reference point;
defining a scaling factor;
transforming the first plurality of GIS data points into a second plurality of GIS data points by defining each of the first plurality of GIS data points using the reference point and the scaling factor.

2. The method for providing GIS data according to claim 1, further including receiving data representing a query for GIS data, and defining the geographic area in response to the query.

3. The method for providing GIS data according to claim 2, further including transmitting data corresponding to the second plurality of GIS data points, data representing the reference point, and data representing the scaling factor to provide a response to the query.

4. The method for providing GIS data according to claim 1, 2 or 3, wherein each of the first plurality of GIS data points is defined by three values representing a latitude, a longitude, and an elevation.

5. A method for compressing geographic information services (GIS) data, including:
defining a geographic area based on a first plurality of GIS data points, each of the first plurality of GIS data points being defined by at least two data values representing at least a latitude and a longitude for the GIS data point, each of the first plurality of GIS data points comprising a first number of data bits;
setting one of the first plurality of GIS data points as a reference point;
defining a scaling factor;
transforming the first plurality of GIS data points into a second plurality of GIS data points by defining each of the first plurality of GIS data points with respect to the reference point using the scaling factor, each of the second plurality of GIS data points comprising a second number of data bits, the second number of data bits being smaller than the first number of data bits.

6. The method according to claim 5, wherein each of the first plurality of GIS data points is defined by three values representing a latitude, a longitude, and an elevation.

7. A method for responding to a query for geographic information services (GIS) data, including:
receiving data representing a query for GIS data;
defining a geographic area in response to the query, the geographic area being defined by a first plurality of GIS data points, each of the first plurality of GIS data points being defined by at least two data values representing at least a latitude and a longitude for the GIS data point, each of the first plurality of GIS data points comprising a first number of data bits;
setting one of the first plurality of GIS data points as a reference point;
defining a scaling factor;
transforming the first plurality of GIS data points into a second plurality of GIS data points by defining each of the first plurality of GIS data points with respect to the reference point using the scaling factor, each of the second plurality of GIS data points comprising a second number of data bits, the second number of data bits being smaller than the first number of data bits; and
transmitting the second plurality of GIS data points, data representing the reference point, and data representing the scaling factor to return a response to the query.

8. An apparatus for compressing GIS data, comprising:
means for receiving a first plurality of GIS data points and storing the first plurality of GIS data points in memory, the first plurality of GIS data points comprising a first number of data bits;
means for defining one of the first plurality of GIS data points as a reference point;
means for defining a scaling factor; and
means for transforming the first plurality of GIS data points into a second plurality of GIS data points based on the reference point and the scaling factor, the second plurality of GIS data points comprising a second number of data bits, the second number of data bits being smaller than the first number of data bits.
